(19) Europäisches Patentamt
European Patent Office
Office européen des brevets

(11) Veröffentlichungsnummer : **0 139 090**
**B1**

(12) # EUROPÄISCHE PATENTSCHRIFT

(45) Veröffentlichungstag der Patentschrift : **27.07.88**

(51) Int. Cl.⁴ : **C 23 C 18/22**

(21) Anmeldenummer : **84107617.7**

(22) Anmeldetag : **30.06.84**

(54) **Verfahren zur Vorbehandlung von Polyimid.**

(30) Priorität : **05.08.83 DE 3328765**

(43) Veröffentlichungstag der Anmeldung : **02.05.85 Patentblatt 85/18**

(45) Bekanntmachung des Hinweises auf die Patenterteilung : **27.07.88 Patentblatt 88/30**

(84) Benannte Vertragsstaaten : **DE FR GB IT NL SE**

(56) Entgegenhaltungen :
**DE-A- 2 239 908**
**DE-A- 3 149 919**
**US-A- 3 652 351**
**US-A- 4 327 157**

(73) Patentinhaber : **SCHERING AKTIENGESELLSCHAFT**
**Berlin und Bergkamen**
**Müllerstrasse 170/178 Postfach 65 03 11**
**D-1000 Berlin 65 (DE)**

(72) Erfinder : **Mahlkow, Hartmut**
**Handjerystrasse 85**
**D-1000 Berlin 41 (DE)**
Erfinder : **Grapentin, Hans-Joachim**
**Wundtstrasse 17**
**D-1000 Berlin 19 (DE)**
Erfinder : **Seidenspinner, Hubert-Matthias, Dr.**
**Attendorner Weg 15**
**D-1000 Berlin 27 (DE)**

**EP 0 139 090 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zur haftfesten Metallisierung von Polyimid gemäß Oberbegriff des Anspruchs 1.

Polyimidfolien werden in zunehmendem Maße anstelle von mit Expoxidharz getränkten Glasfasermatten vorteilhaft auf dem Elektronik-Sektor Verwendung finden. Polyimidfolien kommen nämlich beidseitig kupferkaschiert für Mehrebenenschaltungen, beispielsweise sogenannte Multilayer, in Frage, weil diese über erheblich bessere Isolationswerte verfügen und deshalb bei gleicher Gesamtdicke eines Multilayers wesentlich häufiger als Schicht mit Epoxidharz verpreßt werden können. Die Aufbringung des Kupfers muß hierbei allerdings mittels eines geeigneten Klebers erfolgen, da Polyimid, anders als die auf Epoxidharz basierenden Kunsststoffe, nicht in der Lage ist, aufgewalztes Kupfer haftfest zu binden, was ungünstige Verarbeitungseigenschaften verursacht.

Ein Verfahren zur haftfesten Metallisierung von Polyimid durch Vorbehandlung des Polyimids mit einer wäßrigen Lösung von Alkalihydroxid und einer organischen Stickstoffverbindung ohne die nachteilige Verwendung eines Klebers ist bereits bekannt (DE-OS 31 49 919).

Aufgabe der vorliegenden Erfindung ist die Zurverfügungstellung eines Verfahrens zur Vorbehandlung von Polyimid mit überlegenen Eigenschaften.

Diese Aufgabe wird erfindungsgemäß durch ein Verfahren gemäß dem kennzeichnenden Teil des Patentanspruchs gelöst.

Vorteilhafte Weiterbildungen der Erfindung sind in den Unteransprüchen beschrieben.

Das erfindungsgemäße Verfahren bewirkt im Vergleich zum Stand der Technik eine weitere Steigerung des Verbundes von Polyimid mit dem abgeschiedenen Metallüberzug, die möglicherweise auf chemische Vorgänge zwischen der Polyimidoberfläche und den Behandlungslösungen zurückzuführen ist.

Von besonderem Vorteil ist es, daß diese gesteigerte Haftung mit Polyimid jeglicher Herkunft, das heißt unabhängig von der Qualität des Rohstoffs, erreichbar ist.

Die erfindungsgemäß zu verwendende Lösung kann als zweiwertige Metalle, vorzugsweise Magnesium, Calcium, Mangan, Eisen, Kobalt, Nickel, Palladium, Kupfer, Zink, Kadmium oder Quecksilber in Form ihrer Verbindungen, zum Beispiel der Oxide, der anorganischen oder organischen Salze oder in Form von Komplexen, enthalten.

Von herausragender Wirkung ist Zink, das besondere Haftungssteigerung bewirkt.

Die Metallverbindungen werden in Konzentrationen von 1 bis 20 g/Liter, bevorzugt 10 g/Liter, bezogen auf das Metall, eingesetzt.

Als Alkalihydroxid kann die Lösung Lithiumhydroxid, Natriumhydroxid und/oder Kaliumhydroxid in Konzentrationen von 5 bis 600 g/Liter, vorzugsweise 50 g/Liter, enthalten.

Als organische Stickstoffverbindung kann die Lösung ein primäres, sekundäres oder tertiäres Amin enthalten, wie zum Beispiel ein aliphatisches oder cycloaliphatisches Mono-, Di- oder Polyamin oder deren Hydroxy-, Carboxy-, Sulfo- und/oder Phosphoryl-Derivate, ein aromatisches Mono-, Di- oder Polyamin oder deren Hydroxy-, Carboxy-, Sulfo- und/oder Phosphoryl-Derivate, ein heterocyclisches Mono-, Di- oder Polyamin oder deren Hydroxy-, Carboxy- und/oder Sulfo-Derivate, eine N-haltige ein- oder mehrkernige heterocyclische Verbindung oder deren Hydroxy-, Carboxy- und/oder Sulfo-Derivate, die gegebenenfalls vorzugsweise durch die Alkyl- oder Nitrilogruppe, substituiert sein können.

Als solche Stickstoffverbindungen sind zu nennen :

Methylamin, Äthylamin, Propylamin, Butylamin, Äthylendiamin, Propylendiamin, Isopropylendiamin, Tetramethylendiamin, Octamethylendiamin, Piperidin, Piperazin, Pyrrolidin, Benzylamin, Diäthylendiamin, Äthylendiamintetraessigsäure, Butylendiamintetraessigsäure, Hexamethylendiamintetraessigsäure, Octamethylendiamintetraessigsäure, Nitrilotriessigsäure, Iminodiessigsäure, Äthylendiamin-N,N'-dipropionsäure, Hexamethylendiamin-N,N'-dipropionsäure, Äthylendiamin-tetrakis-isopropanol, Äthylendiamin-tetrakis-äthanol, N,N,N',N'-Tetrakis-(2-hydroxypropyl)-äthylen-diamin, Triäthanolamin, Äthanolamin, O-Phenyldiamin, Anilin, Toluidin, Triäthylamin, Tributylamin, N,N,N',N'-Tetramethyl-äthylendiamin, N,N'-Dimethyl-äthylendiamin, N,N-Dimethyl-äthylendiamin, N-Methyl-äthylendiamin, Diäthylamin, Dibutylamin.

Imidazol, 1-Methyl-imidazol, 1-Propyl-imidazol, 2,4-Dimethyl-imidazol, 4-Methyl-imidazol, 2-Isopropyl-imidazol, 2-Phenyl-imidazol, 1-Benzyl-imidazol, β-Imidazolopropionsäure, 1,2-Dimethyl-imidazol, 1-Methyl-2-hydroxymethyl-imidazol, 4-Sulfo-imidazol, 2-Methyl-4-sulfo-imidazol, 2-(Sulfophenyl)-imidazol, 2-Isopropyl-4-sulfo-imidazol, 1-n-Propyl-5-sulfo-imidazol, 1-n-Propyl-4-sulfo-imidazol, 1,2-Bis-(1'-imidazolyl)-äthan, 1-(p-Sulfophenyl)-imidazol, Histidin, 2-(Imidazolo-äthyl)-pyridin, 1-(2'-Aminoäthyl)-imidazol-hydrochlorid, 1-(3'-Aminopropyl)-imidazol-hydrochlorid, 1-Methyl-2-carboxymethyl-imidazol, 2-(p-Sulfophenyl)-4-sulfo-imidazol, 1-Methyl-2-sulfo-imidazol, 2-Sulfoimidazol, 1,2-Bis-(1'-methyl-5'-imidazolyl)-äthan, 5-Sulfo-benzimidazol, 5,7-Disulfobenzimidazol, 1,2-Bis-(5'-sulfobenzimidazolyl-(2'))-äthan, 1,4-Bis-(5'-sulfobenzimidazolyl-(2'))-butan, Polyvinylimidazol (Polymerisationsgrad = 2 bis 500), Polyallylimidazol (Polymerisationsgrad = 2 bis 500), 3,5-Dimethylpyrazol, 4-Sulfopyrazol, 1-Methylpyrazol, 3-Methylpyrazol, 1,3-Dimethylpyrazol, 1-Phenylpyrazol, 1-Carboxymethyl-pyrazol, 1-Carboxyäthylpyrazol, 1-Aminoäthylpyrazol-hydrochlorid, 1-Aminopropylpyrazol-hydrochlorid, 3,3-Dipyrazolyl, 1,3-Dimethyl-5-hydroxy-pyrazol, 1-Phenyl-3-methyl-5-hydroxy-pyrazol, 1-(p-Sulfophenyl)-3-methyl-5-hydroxy-pyrazol, 1-(m-Sulfophenyl)-3-methyl-5-hydroxy-pyrazol, 1-(p-Aminophenyl)-3-methyl-5-hydroxy-pyrazol, 1-(p-Chlorphenyl)-3-methyl-5-hydroxy-pyrazol, 1-(p-Sulfophenyl)-3-carboxy-5-hydroxy-pyrazol, 1,2-Bis-(1'-pyrazolyl)-äthan, 7-Sulfo-benzpyrazol, 1-Carboxyäthyl-benzpyrazol, 1,2-Bis-(3'-pyrazolyl)-äthan, Di-(3-pyrazolyl)-methan.

Pyridin, 2-Aminopyridin, 3-Aminopyridin, 4-Aminopyridin, 2-Hydroxypyridin, 3-Hydroxypyridin, 4-Hydroxypyridin, 2,6-Diaminopyridin, 2,3-Diaminopyridin, 3,4-Diaminopyridin, 2-Amino-methyl-pyridin, 3-Aminomethyl-pyridin, 4-Amino-methyl-pyridin, 4-Picolin, 3-Picolin, 2-Picolin, 2,6-Lutidin, 2,4-Lutidin, 3-Pyridinsulfonsäure, 2,2'-Dipyridyl, 1,2-Di-(2'-pyridyl), 2,2'-Dipyridylmethan, 2,2'-Dipyridyl-amin, 1,2-Dihydroxy-1,2-di-(2'-pyridyl)-äthan, 2,2'-Dipyridyl-äthylen, 4,4'-Dipyridyl-äthylen, 3-Sulfo-3,3'-dipyridyl, 1,2-Di-(4'-pyridyl)-äthan.

2-Amino-pyrimidin, 2,4,6-Triamino-pyrimidin, 1,4-Dimethyl-pyrimidin, 1,5-Dimethyl-pyrimidin, 4,5-Dimethylpyrimidin, 4,6-Dimethylpyrimidin, 2,4-Bis-(diäthylamino)-pyrimidin, 3,6-Bis-(dimethylamino)-pyrimidin, 3,6-Bis-(äthylamino)-pyrimidin, 2-Hydroxypyrimidin, 4-Hydroxypyrimidin, 4,6-Dihydroxy-pyrimidin, Barbitursäure, Cytosin, Pyrimidin, Bis-(2-methyl-4-pyrimidyl),2,2'-Dipyrimidyl, 4,4'-Dipyrimidyl, Uracil, 5-Methyl-cytosin, 2-Methyl-pyrimidin, 2-Äthyl-pyrimidin, 2-Phenyl-pyrimidin, 2-Amino-6-äthyl-pyrimidin, 2-Amino-6-methyl-pyrimidin, 2-Amino-5-methoxy-pyrimidin, 2-Amino-4-hydroxy-pyrimidin, 2-Carboxy-pyrimidin, 5-Carboxymethyl-pyrimidin, 2-Carboxymethyl-5,6-dimethyl-pyrimidin, 2-Methyl-5-carboxymethyl-pyrimidin, Pyridazin, 3-Methyl-pyridazin, Pyrazin, 2,3,5,6-Tetramethyl-pyrazin, 2,5-Dimethyl-6-hydroxy-pyrazin, 2-Hydroxy-pyrazin, 2-Amino-pyrazin.

Urotropin, 2,6-Diamino-4-methyl-triazin-(1,3,5), 2,6-Di-amino-4-äthyl-triazin-(1,3,5), 2,6-Diamino-4-propyl-triazin-(1,3,5), 2,6-Diamino-4-carboxymethyl-triazin-(1,3,5), 2,6-Diamino-4-carboxyäthyl-triazin-(1,3,5), 2,6-Diamino-4-sulfopropyl-triazin-(1,3,5), Melamin, Cyanursäure, 2,4,6-Tris-methylamino-triazin-(1,3,5), 2,4,6-Tris-äthylamino-triazin-(1,3,5), 2,4,6-Tris-diäthylamino-triazin-(1,3,5), Bis-(4,6-diamino-2-triazinyl-(1,3,5))-methan, 1,2-Bis-(4',6'-diamino-triazinyl-(1',3',5'))-äthan, 1,3-Bis-(4',6'-diamino-2'-triazinyl-(1',3',5'))-propan,1,2-Bis-(4',6'-diamino-triazinyl-2'-amino)-äthan, 2,4-Diamino-triazin-(1,3,5), 2,4-Diamino-6-(p-sulfophenyl)-triazin-(1,3,5), 2,4-Diamino-6-äthyl-triazin-(1,3,5), 2,4-Dihydroxy-6-methyl-triazin-(1,3,5), Cyanursäure-hydroxyäthylester, 2,4-Dihydroxy-6-carboxymethyl-triazin-(1,3,5), 2-Amino-4-carboxymethyl-6-n-butylamino-triazin-(1,3,5), 2-Amino-4-carboxy-6-n-butylamino-triazin-(1,3,5), 2-Amino-4-carboxyäthyl-6-n-butylamino-triazin-(1,3,5), 2-Amino-4-hydroxytriazin-(1,3,5), 3-Amino-triazin-(1,2,4), 3-Amino-5,6-dimethyl-triazin-(1,2,4), 4-Hydroxy-5,6-dimethyl-triazin-(1,2,4), 4-Hydroxy-5-phenyl-triazin-(1,2,4), Triazin-(1,2,4) 3,3'-Bis-(5,6-dimethyl-triazin)-(1,2,4), 3,5-Dihydroxy-triazin-(1,2,4), 3,5-Dihydroxy-6-methyl-triazin-(1,2,4), 3,5-Dihydroxy-6-butyl-triazin-(1,2,4), 3,5-Dihydroxy-6-phenyl-triazin-(1,2,4), 3,5-Dihydroxy-6-carboxypropyl-triazin-(1,2,4).

Triazol-(1,2,4), 4-Äthyl-triazol-(1,2,4), 4-Methyl-triazol-(1,2,4), 4-Phenyl-triazol-(1,2,4), 3,4,5-Trimethyltriazol-(1,2,4), 4-(p-Sulfophenyl)-triazol-(1,2,4), 3-Methyl-triazol-(1,2,4), 3-Äthyl-triazol-(1,2,4), 3,5-Dimethyl-triazol-(1,2,4), 3-Phenyl-triazol-(1,2,4), 1-Methyl-triazol-(1,2,4), 1-Äthyl-triazol-(1,2,4), 1-Phenyl-triazol-(1,2,4), 3-Sulfo-triazol-(1,2,4), 3-Amino-triazol-(1,2,4), 3,5-Diamino-triazol-(1,2,4), 1,2-Bis-(5'-sulfo-3'-triazolyl)-äthan, 1,2-Bis-(5'-amino-3'-triazolyl)-äthan, 1,2-Bis-(3'-triazolyl)-äthan, 1,2-Bis-(4'-methyl-3'-triazolyl)-äthan, Bis-(3-triazolyl)-methan, Bis-(5-sulfo-3-triazolyl)-methan, Bis-(5-amino-3-triazolyl)-methan, Bis-(3-triazolyl)-methan, Bis-(5-sulfo-3-triazolyl), Bis-(5-amino-3-triazolyl), 3,3'-Bis-triazolyl, 1,2-(1'-triazolyl)-äthan, 3-(2'-aminoäthyl)-triazol-(1,2,4), β-(1-Triazolyl)-propionsäure, 1,4-Bis-(5'-sulfo-3'-triazolyl)-butan, 1,4-Bis-(5'-amino-3'-triazolyl)-butan, 1-(3-Sulfopropyl)-triazol-(1,2,4), 1,2-Bis-(4'-triazolyl)-äthan, 1-Methyl-triazol-(1,2,3), 1-Äthyl-triazol-(1,2,3), 2-Äthyl-triazol-(1,2,3), 2-Propyltriazol-(1,2,3), 1-(2'-Carboxyäthyl)-triazol-(1,2,3), 5-Sulfobenzotriazol, 5,7-Disulfo-benzotriazol, Benzotriazol, 4-Methyl-triazol-(1,2,3), 4,5-Dimethyl-triazol-(1,2,3), 4-Butyl-triazol-(1,2,3), 4-Phenyl-triazol-(1,2,3), 1-(3'-Aminopropyl)-triazol-(1,2,3), 1-(2'-Aminoäthyl)-triazol-(1,2,3), 1,2-Bis-(1'-triazolyl)-äthan.

Pyrrol, 1-Methyl-pyrrol, 1-Äthyl-pyrrol, 1-(2'-Carboxy-äthyl)-pyrrol, 2-Methyl-pyrrol, 2,5-Dimethyl-pyrrol, Di-(2-pyrrolyl)-methan, Di-(1-methyl-2-pyrrolyl)-methan, 2-Äthyl-pyrrol, Tryptophan.

Polyäthylenimin, N,N-Dimethyl-polyvinylamin, Polyvinylimidazol, Polyallylimidazol, Polyvinylpyridin, Polyvinylpyrrolidon, Polyvinylmorpholin, Polyvinylmorpholinon, Polyvinyl-5-alkyl-oxazolidon, N-Polyvinyl-N,N'-äthylenharnstoff, Sojaproteine Albumine, Äthylendiamintetra-(methylphosphonsäure), Hexamethylphosphontriamid.

Es versteht sich, daß die Verbindungen jeweils allein oder auch in Mischung miteinander eingesetzt werden können.

Von besonderer Bedeutung sind N,N,N',N'-Tetrakis-(2-hydroxy-propyl)-äthylendiamin, Äthylendiamintetraessigsäure und Nitrilotriessigsäure, bei deren Verwendung sich ein verstärkter inniger Verbund von Polyimid mit dem Metallüberzug ergibt.

Die organischen Stickstoffverbindungen werden in Konzentrationen von 5 bis 30 g/Liter, vorzugsweise 20 g/Liter, eingesetzt.

Als Polyimid sollen alle Kunststoffe verstanden werden, wie sie zum Beispiel in Ullmanns Encyklopädie der technischen Chemie, 1970, Ergänzungsband, Seiten 266 bis 268 und Seiten 318 bis 319, Verlag Urban & Schwarzenberg, München, Berlin, Wien, beschrieben sind.

Ihre Herstellung kann in an sich bekannter Weise, zum Beispiel durch Reaktion von Carbonsäureanhydriden mit aromatischen Diaminen, erfolgen.

Es handelt sich um weitgehend lineare, hoch wärmestabile Kunststoffe der allgemeinen Formel

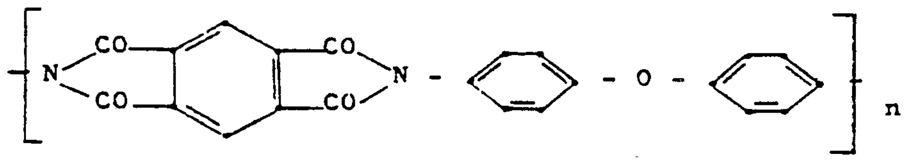

Das Polyimid wird vorteilhafterweise in Folienform für das erfindungsgemäße Verfahren verwendet.

Es versteht sich, daß nicht nur Kunststoffe aus reinem Polyimid erfindungsgemäß behandelt werden können, sondern auch solche, die zum Beispiel einseitig mit anderen Kunststoffen beschichtet sind.

Die Behandlung des Polyimids mit der erfindungsgemäß zu verwendenden Lösung erfolgt bei Temperaturen von 15 bis 30 °C, vorzugsweise 20 °C.

Nach erfolgter Vorbehandlung wird das Polyimid in üblicher Weise aktiviert, zweckmäßigerweise mittels eines palladiumhaltigen Aktivators, worauf in üblicher Weise chemisch metallisiert, vorzugsweise verkupfert oder vernickelt, wird.

Eine besonders innige Haftung läßt sich erreichen, wenn das Polyimid nach erfolgter Vorbehandlung und Metallisierung auf 70 bis 140 °C, vorzugsweise 130 °C, erhitzt wird.

Eine weitere Steigerung der Haftung des abgeschiedenen Metallüberzugs läßt sich schließlich erreichen, wenn das Polyimid nach erfolgter Vorbehandlung zunächst in eine Ammoniumionen enthaltende wäßrige Lösung getaucht wird, wozu organische und anorganische Ammoniumsalze, wie zum Beispiel Ammoniumacetat, geeignet sind.

Es hat sich außerdem als vorteilhaft erwiesen, ein Palladiumreduktionsbad zu verwenden, das ein N-haltiges, kationaktives Netzmittel enthält. Geeignete Netzmittel sind beispielsweise quaternisierte Fettaminopolyglykoläther der allgemeinen Formel

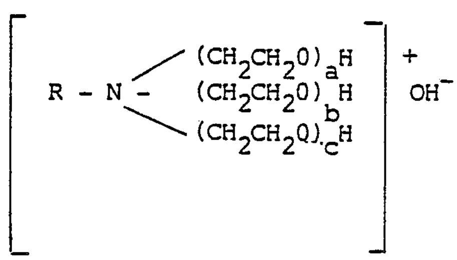

in der R einen Alkylrest, vorzugsweise mit 12 bis 18 C-Atomen, und $a + b + c = 10$ bedeuten. Diese Netzmittel werden zweckmäßigerweise in Konzentrationen von 0,005 bis 2 g/Liter, vorzugsweise 0,05 g/Liter, angewendet.

Die nachfolgende Verwendung eines ebenfalls Ammoniumionen enthaltenden chemischen Metallisierungsbades führt schließlich zu einer nachhaltigen Steigerung der Haftung.

Die erfindungsgemäß zu verwendende Lösung erlaubt in überraschend vorteilhafter Weise die Herstellung eines Polyimid-Metall-Verbund-Werkstoffes, vorzugsweise eines Polyimid-Kupfer-Verbund-Werkstoffes, der für Formteile, vorzugsweise auf dem Gebiet der Elektronik und Elektrotechnik, verwendet werden kann.

Die weiteren Vorteile, die mit der Möglichkeit der Herstellung eines solchen Verbund-Werkstoffes verbunden sind, liegen in der Vermeidung all der Fehlerquellen, die mit der sonst erforderlichen Verwendung eines Klebers gegeben sind. Ferner eröffnet sich die Möglichkeit, Polyimid als letzte Lage zur Herstellung von Basismaterial für die Semiadditivtechnik zu benutzen, um auch hier auf die Chromsäure als Aufschlußmaterial verzichten zu können. Hinzu kommen die wesentlich besseren elektrischen Kenndaten, die die Auslegung sehr viel dichterer Schaltbilder gestatten, als das auf herkömmlichen Haftvermittlern möglich ist.

Die erfindungsgemäß hergestellten Verbundwerkstoffe sind überraschenderweise von überlegener Stabilität.

Die folgenden Beispiele dienen zur Erläuterung der Erfindung.

## Beispiel 1

Die in der Elektroindustrie gebräuchliche Polyimidfolie wurde in einer Lösung von 100 g Kaliumhydroxid und 20 g N,N,N',N'-Tetrakis-(2-hydroxypropyl)-äthylendiamin in 1 Liter Wasser 5 Minuten lang behandelt und dann gespült. Im nächsten Schritt wurde die Folie in bekannter Weise mit Palladiumionen aktiviert. Nach dem Spülen in Wasser erfolgte mit einer wäßrigen 1 %igen Dimethylaminoboranlösung die Reduktion der noch verbliebenen adsorbierten Palladiumionen zu Palladiummetall. Derart vorbereitet, gelang die einwandfreie Metallisierung in einem bekannten chemischen Kupferbad mit Formaldehyd als Reduktionsmittel. Zur Fixierung des aufgebrachten chemischen Kupfers wurde nunmehr ein Tempervorgang bei 100 °C angeschlossen. Nach dem Tempern wurde die extrem dünne (0,5 µm) Kupferschicht kurz

mit 10 vol%iger Schwefelsäure desoxidiert und dann in üblicher Weise in einem schwefelsauren galvanischen Kupferbad auf 40 µm verstärkt. Im Schältest nach DIN wurde die Haftung bestimmt. Diese betrug 1 bis 2 N/cm.

Beispiel 2

Zu der im Beispiel 1 beschriebenen Lösung von 100 g Kaliumhydroxid und 20 g N,N,N',N'-Tetrakis-(2-hydroxypropyl)-äthylendiamin in 1 Liter Wasser wurden 10 g Zink als Zinkoxid hinzugegeben. Anschließend wurde eine Polyimidfolie analog wie im Beispiel 1 mit dieser Lösung vorbehandelt, dann aktiviert und chemisch sowie galvanisch verkupfert. Die Haftung (Schältest nach DIN) betrug 4 bis 5 N/cm.

Beispiel 3

Der im Beispiel 2 beschriebene Versuch wurde unter Verwendung einer Dimethylaminoboranlösung als Reduktionsmittel wiederholt, die 0,05 g eines quaternisierten Fettaminopolyglykoläthers enthielt.

Die Haftung wurde mit 5 bis 7 (Schältest nach DIN) bestimmt.

Beispiel 4

Der im Beispiel 3 beschriebene Versuch wurde wiederholt, wobei jedoch die Polyimidfolie nach erfolgter Vorbehandlung in eine 20 g Ammoniumacetat/Liter Wasser enthaltende Lösung getaucht wurde.

Die Haftung (Schältest nach DIN) betrug 11 bis 16 N/cm.

**Patentansprüche**

1. Verfahren zur haftfesten Metallisierung von Polyimid durch Vorbehandlung des Polyimids und anschließende Aktivierung sowie chemische und galvanische Metallabscheidung, wobei das Polyimid mit einer wässrigen Lösung von Alkalihydroxid und/oder einer wässrigen Lösung von Alkalihydroxid und einer organischen Stickstoffverbindung vorbehandelt wird, dadurch gekennzeichnet, daß die Lösung zusätzlich ein zweiwertiges Metall in Form seiner Verbindungen in Konzentrationen von 1 bis 20 g/Liter enthält.

2. Verfahren gemäß Anspruch 1, dadurch gekennzeichnet, daß das zweiwertige Metall Magnesium, Calcium, Mangan, Eisen, Kobalt, Nickel, Palladium, Kupfer, Zink, Kadmium oder Quecksilber darstellt.

3. Verfahren gemäß Anspruch 1, dadurch gekennzeichnet, daß die Lösung als Alkalihydroxid Lithiumhydroxid, Natriumhydroxid und/oder Kaliumhydroxid enthält.

4. Verfahren gemäß Anspruch 1, dadurch gekennzeichnet, daß die Lösung 5 bis 600 g/Liter Alkalihydroxid enthält.

5. Verfahren gemäß Anspruch 1, dadurch gekennzeichnet, daß die Lösung als organische Stickstoffverbindung ein primäres, sekundäres oder tertiäres Amin enthält.

6. Verfahren gemäß Anspruch 5, dadurch gekennzeichnet, daß die Lösung als organische Stickstoffverbindung ein aliphatisches oder cycloaliphatisches Mono-, Di- oder Polyamin oder deren Hydroxy-, Carboxy-, Sulfo- und/oder Phosphoryl-Derivate, ein aromatisches Mono-, Di- oder Polyamin oder deren Hydroxy-, Carboxy-, Sulfo und/oder Phosphoryl-Derivate, ein heterocyclisches Mono-, Di- oder Polyamin oder deren Hydroxy-, Carboxy- und/oder Sulfo-Derivate, eine N-haltige ein- oder mehrkernige heterocyclische Verbindung oder deren Hydroxy-, Carboxy- und/oder Sulfo-Derivate enthält.

7. Verfahren gemäß Anspruch 6, dadurch gekennzeichnet, daß die Lösung als organische Stickstoffverbindung N,N,N',N'-Tetrakis-(2-hydroxypropyl)-äthylendiamin, Äthylendiamintetraessigsäure oder Nitrilotriessigsäure enthält.

8. Verfahren gemäß Anspruch 1, dadurch gekennzeichnet, daß die Lösung 5 bis 30 g/Liter einer organischen Stickstoffverbindung enthält.

9. Verfahren gemäß Anspruch 1, dadurch gekennzeichnet, daß die Vorbehandlung bei Temperaturen von 15 bis 30 °C, durchgeführt wird.

10. Verfahren gemäß Anspruch 1, dadurch gekennzeichnet, daß das Polyimid nach erfolgter Vorbehandlung zunächst in eine Ammoniumionen enthaltende wässrige Lösung getaucht wird.

11. Verfahren gemäß Anspruch 1, dadurch gekennzeichnet, daß ein Palladiumreduktionsbad verwendet wird, das ein N-haltiges, kationaktives Netzmittel in Konzentrationen von 0,005 bis 2 g/Liter enthält.

12. Verfahren gemäß Anspruch 11, dadurch gekennzeichnet, daß das Netzmittel einen quaternisierten Fettaminpolyglykoläther der allgemeinen Formel

(Siehe Formel Seite 6 f.)

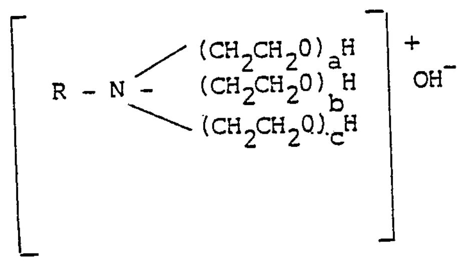

darstellt, worin R einen Alkylrest, vorzugsweise mit 12 bis 18 C-Atomen, und a + b + c = 10 bedeuten.

13. Verfahren gemäß Anspruch 1, dadurch gekennzeichnet, daß die chemische Metallisierung mittels eines Ammoniumionen enthaltenden chemischen Bades erfolgt.

14. Verfahren gemäß Anspruch 1, dadurch gekennzeichnet, daß das Polyimid nach erfolgter Vorbehandlung und Metallisierung auf 70 bis 140 °C erhitzt wird.

15. Verfahren gemäß Ansprüchen 1 bis 14 zur Herstellung eines Polyimid-Metall-Verbund-Werkstoffes.

**Claims**

1. Method for strongly adherent metallization of polyimide by pretreatment of the polyimide and subsequent activation and metal deposition by chemical or electroplating processes, the polyimide being pretreated with an aqueous solution of an alkali hydroxide and/or an aqueous solution of an alkali hydroxide mixed with an organic nitrogen compound, characterized in that the solution additionally contains a bivalent metal in the form of its compounds in concentrations of 1 to 20 g/litre.

2. Method in accordance with claim 1, characterized in that the bivalent metal is magnesium, calcium, manganese, iron, cobalt, nickel, palladium, copper, zinc, cadmium or mercury.

3. Method in accordance with claim 1, characterized in that the solution contains lithium hydroxide, sodium hydroxide and/or potassium hydroxide as the alkali hydroxide.

4. Method in accordance with claim 1, characterized in that the solution contains 5 to 600 g of alkali hydroxide per litre.

5. Method in accordance with claim 1, characterized in that the solution contains a primary, secondary or tertiary amine as the organic nitrogen compound.

6. Method in accordance with claim 5, characterized in that the solution contains, as the organic nitrogen compound, an aliphatic or cycloaliphatic mono, di or polyamine or their hydroxy, carboxy, sulfo and/or phosphoryl derivatives, an aromatic mono, di or polyamine or their hydroxy, carboxy, sulfo and/or phosphoryl derivatives, a heterocyclic mono, di or polyamine or their hydroxy, carboxy and/or sulfo derivatives or a nitrogen-containing mono or polynuclear heterocyclic compound or their hydroxy, carboxy and/or sulfo derivatives.

7. Method in accordance with claim 1, characterized in that the solution contains N,N,N',N'-tetrakis-(2-hydroxypropyl)-ethylenediamine, ethylenediaminetetraacetic acid or nitrilotriacetic acid.

8. Method in accordance with claim 1, characterized in that the solution contains 5 to 30 g of an organic nitrogen compound per litre.

9. Method in accordance with claim 1, characterized in that pretreatment is carried out at temperatures from 15 to 30 °C.

10. Method in accordance with claim 1, characterized in that the polyimide after pretreatment is dipped first into an aqueous solution containing ammonium ions.

11. Method in accordance with claim 1, characterized in that a palladium reduction bath is used which contains a N-containing cation-active wetting agent at concentrations of 0.005 to 2 g/litre.

12. Method in accordance with claim 1, characterized in that the wetting agent is a quaternized fatty amine polyglycol ether of the general formula

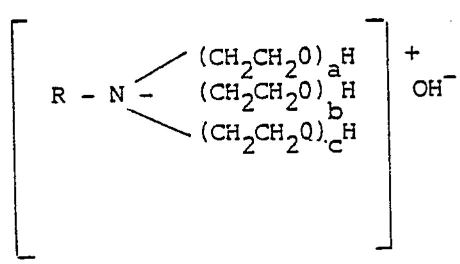

where R is an alkyl radical, preferably with 12 to 18 C-atoms, and a + b + c = 10.

13. Method in accordance with claim 1, characterized in that the chemical metallizing process takes place by means of a chemical bath containing ammonium ions.

14. Method in accordance with claim 1, characterized in that the polyimide after pretreatment and metallizing is heated to a temperature from 70 to 140 °C.

15. Method in accordance with claims 10 to 14 for producing a composite polyimide-metal material.

**Revendications**

1. Procédé pour réaliser, sur une matière en polyimide, un dépôt métallique qui adhère bien, par prétraitement du polyimide, puis activation et métallisation par voie chimique et par voie galvanique, le polyimide étant prétraité par une solution aqueuse d'un hydroxyde de métal alcalin et/ou par une solution aqueuse d'un hydroxyde de métal alcalin et d'un composé organique azoté, procédé caractérisé en ce que la solution contient en plus un métal bivalent sous la forme d'un de ses composés, en des concentrations de 1 à 20 g/litre.

2. Procédé selon la revendication 1 caractérisé en ce que le métal bivalent est le magnésium, le calcium, le manganèse, le fer, le cobalt, le nickel, le palladium, le cuivre, le zinc, le cadmium ou le mercure.

3. Procédé selon la revendication 1 caractérisé en ce que la solution contient, comme hydroxyde de métal alcalin, de l'hydroxyde de lithium, de l'hydroxyde de sodium et/ou de l'hydroxyde de potassium.

4. Procédé selon la revendication 1 caractérisé en ce que la solution contient de 5 à 600 g/litre d'un hydroxyde de métal alcalin.

5. Procédé selon la revendication 1 caractérisé en ce que la solution contient, comme composé organique azoté, une amine primaire, secondaire ou tertiaire.

6. Procédé selon la revendication 5 caractérisé en ce que la solution contient, comme composé organique azoté, une monoamine, diamine ou polyamine aliphatique ou cycloaliphatique ou un dérivé hydroxy, carboxy, sulfo et/ou phosphoryle d'une telle amine, une monoamine, diamine ou polyamine aromatique ou l'un de ses dérivés hydroxy, carboxy, sulfo et/ou phosphoryles, une monoamine, diamine ou polyamine hétérocyclique ou l'un de ses dérivés hydroxy, carboxy et/ou sulfo, un composé hétérocyclique azoté à un ou plusieurs noyaux ou l'un de ses dérivés hydroxy, carboxy et/ou sulfo.

7. Procédé selon la revendication 6 caractérisé en ce que la solution contient, comme composé organique azoté, de la N,N,N',N'-tétrakis-(hydroxy-2 propyl)-éthylène-diamine, de l'acide éthylène-diamine-tétracétique ou de l'acide nitrilo-triacétique.

8. Procédé selon la revendication 1 caractérisé en ce que la solution contient de 5 à 30 g/litre d'un composé organique azoté.

9. Procédé selon la revendication 1 caractérisé en ce que le prétraitement est effectué à des températures de 15 à 30 °C.

10. Procédé selon la revendication 1 caractérisé en ce que le polyimide, après le pré-traitement, est plongé d'abord dans une solution aqueuse contenant des ions d'ammoniums.

11. Procédé selon la revendication 1 caractérisé en ce qu'on utilise un bain de réduction du palladium qui contient un mouillant cationique azoté à une concentration de 0,005 à 2 g/litre.

12. Procédé selon la revendication 11 caractérisé en ce que le mouillant est un produit de polyéthoxylation d'une amine grasse, quaternisé, qui répond à la formule générale suivante :

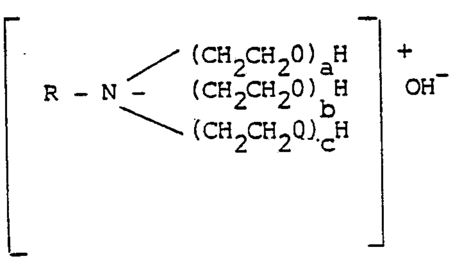

dans laquelle R représente un alkyle, de préférence un radical alkyle contenant de 12 à 18 atomes de carbone, et la somme (a + b + c) est égale à 10.

13. Procédé selon la revendication 1 caractérisé en ce que la métallisation chimique est effectuée au moyen d'un bain chimique renfermant des ions d'ammoniums.

14. Procédé selon la revendication 1 caractérisé en ce que le polyimide, après le pré-traitement et la métallisation, est chauffé à une température de 70 à 140 °C.

15. Procédé selon l'une quelconque des revendications 1 à 14 pour la fabrication d'un matériau composite polyimide/métal.